# DEMANDE DE BREVET EUROPEEN

(11) **EP 1 975 633 A1**
(43) Date de publication de la demande: **01.10.2008**
(21) Numéro de dépôt: 08103150.2
(22) Date de dépôt: 28.03.2008
(51) Int. Cl.: G01R 29/24, H03M 1/80, H03M 1/40

(54) **Dispositif de mesure d`une charge électrique sous forme numérisée**

(30) Priorité: 30.03.2007 FR 0702348
(71) Demandeur: Commissariat A L'Energie Atomique - CEA, 75015 Paris (FR)
(72) Inventeur: Chamming`s, Gilles, 38100 Grenoble (FR)
(74) Mandataire: Lucas, Laurent Jacques

(57) **Abrégé**

La présente invention concerne un dispositif de mesure d'une charge électrique sous forme numérisée.

La valeur numérisée étant codée sur N bits, le dispositif comporte au moins :
- une batterie de N condensateurs (1, 11) intégrant la charge, les condensateurs ayant une électrode commune reliée à une source de courant fournissant la charge, chaque condensateur ayant une électrode individuelle, les valeurs des capacités des condensateurs étant en progression géométrique, un condensateur correspondant à un bit de la valeur numérisée ;
- des commutateurs (100, 101, 102, 103, 104) connectés sur chaque électrode individuelle fonctionnant selon deux phases, connectant dans une phase d'intégration les condensateurs en parallèle pour intégrer la charge dans les condensateurs (1, 11) et permettant dans une phase de numérisation de porter chacune des électrodes individuelles à deux potentiels distincts, correspondant aux deux états logiques du bit, pour transférer ou ne pas transférer la charge portée par le condensateur à l'ensemble des autres condensateurs de la batterie ;
ledit dispositif comportant une unité logique (20) permettant de déterminer dans le deuxième mode la combinaison de condensateurs qui, contenant la même quantité de charge, se trouve à un potentiel défini, la combinaison représentant la valeur numérisée.

## Description

La présente invention concerne un dispositif de mesure d'une charge électrique sous forme numérisée.

Certaines mesures de grandeurs physiques peuvent être représentées par un courant électrique. Il peut être par ailleurs nécessaire d'intégrer ce courant par rapport au temps, par exemple :
- lorsqu'un capteur fournit une mesure sous la forme d'un courant électrique et que, pour diverses raisons, on souhaite intégrer ce courant pendant une période de temps donnée, c'est notamment le cas dans le domaine de l'imagerie visible et infrarouge ;
- lorsqu'un capteur fournit une mesure sous la forme d'une impulsion de courant, de durée finie, dont l'intégrale par rapport au temps représente une quantité de charge finie, c'est notamment le cas de l'imagerie gamma et à rayons X ;
- de façon générale, lorsqu'une donnée ou une grandeur physique est représentée sous forme électrique par la différence de potentiel aux bornes d'une capacité.

Dans tous ces cas, en général pour être exploitée la mesure de courant intégré doit être numérisée. La valeur numérisée peut alors être exploitée par des moyens de traitement numérique ou à base de microprocesseurs.

Un but de l'invention est notamment de permettre l'obtention d'une lecture numérique d'une mesure de courant intégré. A cet effet, l'invention a pour objet un dispositif de mesure d'une charge électrique sous forme d'une valeur numérisée codée sur N bits, comportant au moins :
- une batterie de N condensateurs pour intégrer la charge, les condensateurs ayant une électrode commune destinée à être reliée à une source de courant fournissant la charge, chaque condensateur ayant une électrode individuelle, les valeurs des capacités des condensateurs étant en progression géométrique, un condensateur correspondant à un bit Q de la valeur numérisée ;
- des commutateurs connectés sur chaque électrode individuelle fonctionnant selon deux phases : une phase d'intégration et une phase de numérisation ;
- des moyens pour commander les commutateurs, ces commutateurs connectent dans la phase d'intégration les condensateurs en parallèle pour intégrer la charge dans les condensateurs et permettent dans une phase de numérisation de porter chacune des électrodes individuelles à des premier et second potentiels distincts, correspondant aux deux états logiques du bit, pour transférer ou ne pas transférer la charge portée par le condensateur à l'ensemble des autres condensateurs de la batterie ;
- une unité logique pour réaliser, dans la phase de numérisation, N tests appliqués successivement à chacun des N condensateurs de la batterie, chaque test consistant à relier l'électrode individuelle du condensateur testé au premier potentiel, à comparer le potentiel atteint par l'électrode commune à un potentiel défini (Vseuil), à définir la valeur du bit Q correspondant au condensateur testé en fonction du résultat de comparaison, puis à relier l'électrode individuelle au second potentiel uniquement si le bit Q est égal à une valeur prédéfinie.

Dans un mode de réalisation particulier, une électrode individuelle d'un condensateur est connectée un circuit de transfert de charge comportant des commutateurs, ladite électrode étant reliée électriquement :
- à un potentiel haut par deux commutateurs en série, un premier commutateur étant commandé à l'état passant dans la phase de numérisation, l'état de l'autre commutateur étant fonction de l'état Q mémorisant la valeur du bit associé au condensateur ;
- à un potentiel bas, par deux commutateurs en série, un premier commutateur étant commandé à l'état passant dans la phase d'intégration, l'état de l'autre commutateur étant fonction de l'état inverse de l'état Q précédent.

Le dispositif comporte par exemple un commutateur pour initialiser la tension entre les électrodes des condensateurs.

Avantageusement, il peut comporter un circuit d'échantillonnage du potentiel défini en fin de phase de numérisation. Ce circuit d'échantillonnage comporte par exemple un condensateur en série avec un commutateur.

Dans un mode de réalisation à basse impédance d'entrée, chaque électrode individuelle est par exemple connectée en série avec un commutateur la reliant électriquement à la sortie d'un amplificateur, une entrée de l'amplificateur étant reliée à un potentiel de référence et l'autre entrée étant reliée à l'électrode commune, le commutateur étant commandé à la fermeture pendant la phase d'intégration.

Dans un mode de réalisation à haute impédance d'entrée, chaque électrode individuelle est par exemple connectée en série avec un commutateur la reliant électriquement à un potentiel fixe, le commutateur étant commandé à la fermeture pendant la phase d'intégration.

L'invention a notamment pour principaux avantages qu'elle permet d'obtenir une surface totale de condensateur beaucoup moins élevée que dans une solution classique, qu'elle permet une double lecture numérique et analogique et qu'elle est insensible aux capacités parasites de circuits d'entrée.

D'autres caractéristiques et avantages de l'invention apparaîtront à l'aide de la description qui suit faite en regard de dessins annexés qui représentent :
- la figure 1, un premier exemple de réalisation d'un dispositif selon l'invention, fonctionnant en basse impédance d'entrée ;
- la figure 2, un deuxième exemple de réalisation d'un dispositif selon l'invention, fonctionnant en haute impédance d'entrée ;
- la figure 3, un exemple de signaux de commandes de commutateurs et de tests générés pour un dispositif selon l'invention.

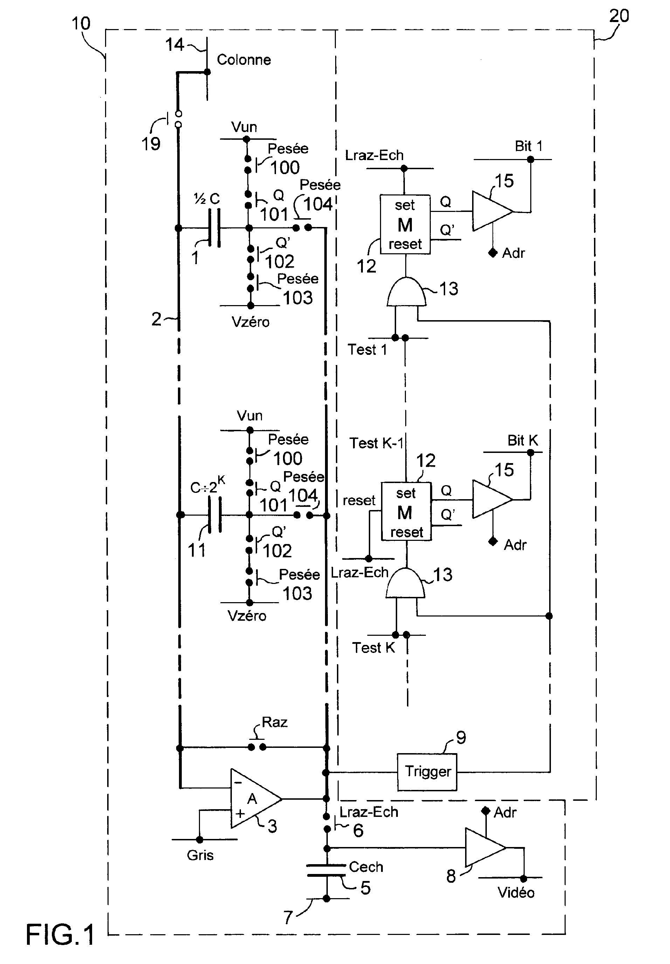

La figure 1 illustre un premier exemple de réalisation d'un dispositif selon l'invention, en version basse impédance. Il comporte une partie analogique 10 destinées notamment au stockage de la charge électrique à mesurer et une partie numérique 20 pour numériser la valeur de la charge stockée.

La partie analogique 10 comporte une batterie de N condensateurs 1, 11 connectés en parallèle. Les valeurs des capacités des condensateurs sont en progression géométrique binaire. Ainsi, la valeur de la capacité du premier condensateur 1 ayant par exemple la valeur C/2, un condensateur 11 d'ordre k a alors une valeur de capacité égale à C/2^{k}. Ces condensateurs servent au stockage de la charge électrique inconnue à mesurer. Ils ont une électrode commune 2 connectée à une entrée d'un amplificateur opérationnel 3. L'autre entrée de l'amplificateur 3 est reliée à un potentiel de référence V_{Gris}. Cet amplificateur 3 comporte par exemple un fort gain.

Chaque condensateur a par ailleurs une électrode individuelle qui peut être connectée selon plusieurs branchements possibles. Dans un mode de fonctionnement un branchement connecte les N condensateurs en parallèle. Dans un autre mode de fonctionnement, un branchement permet le déversement de la charge accumulée dans un condensateur vers les autres condensateurs.

Ces branchements utilisent des commutateurs 100, 101, 102, 103, 104. Une électrode individuelle est ainsi reliée à un premier potentiel haut Vun par l'intermédiaire de deux commutateurs 100, 101 en série, puis elle est reliée à un deuxième potentiel bas Vzéro par l'intermédiaire de deux autres commutateurs en série 102, 103. Enfin elle est reliée à la sortie de l'amplificateur 3 par l'intermédiaire d'un commutateur en série 104.

Les tensions Vun et Vzéro sont choisis égaux aux valeurs extrêmes pouvant être atteintes par la sortie de l'amplificateur 3 lors de la phase d'intégration, c'est-à-dire son excursion de sortie avec une linéarité satisfaisante.

Dans un mode de réalisation particulier, les condensateurs ont par exemple une armature commune formant une première électrode, chaque condensateur ayant par ailleurs une armature individuelle formant l'autre électrode. Un commutateur 4 connecté aux bornes des condensateurs permet, lorsqu'il est en position fermée, une remise à zéro des charges et une réinitialisation de la tension à ces bornes.

La sortie de l'amplificateur 3 est connectée à un condensateur d'échantillonnage 5, via un commutateur commun 6 à tous les condensateurs, notamment pour mémoriser sous forme analogique la valeur finale d'intégration. A cet effet, une électrode du condensateur d'échantillonnage 5 reliée au commutateur Lraz-Ech est par ailleurs reliée à un amplificateur suiveur 8 pour la lecture de cette valeur analogique, commune à toutes les voies. L'autre électrode du condensateur 5 est reliée à un potentiel de référence 7, par exemple la masse mécanique.

Le courant de charge des condensateurs 1, 11 est par exemple amené par une colonne 14 qui est raccordée à une source de courant haute impédance.

La partie numérique 20 complète la partie analogique 10. Elle permet la numérisation de l'information analogique stockée dans les condensateurs 1, 11. Elle s'ajoute notamment à la lecture analogique fournie par l'amplificateur suiveur 8. La partie logique fournit une valeur codée sur N bits, N étant le nombre de condensateurs en parallèle, elle comporte notamment :
- une bascule, appelée encore « trigger » dans la littérature anglo-saxonne, dont l'entrée est connectée à la sortie de l'amplificateur 3 à fort gain, ce « trigger » formant un comparateur à faible hystérésis ;
- pour chaque bit de codage, une mémoire 12, de type RS ou autre, et une porte logique 13 à trois états pour la lecture de cette mémoire.

Une entrée de chaque porte est reliée à la sortie du « trigger » 9, l'autre entrée étant reliée à une entrée de test. Une sortie Q de la mémoire 12 donne la valeur du bit, 0 ou 1. Chaque sortie Q attaque par exemple un circuit d'amplification 15, ou « buffer », l'information binaire véhiculée par le bit étant lue en sortie de ce « buffer ».

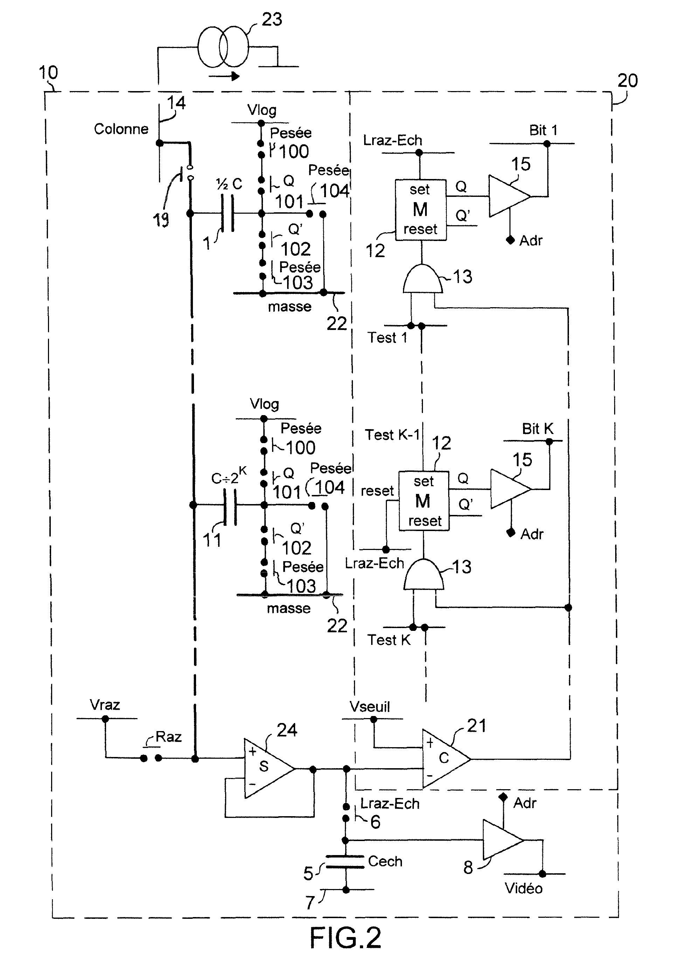

La figure 2 illustre un autre mode de réalisation d'un dispositif selon l'invention, en version haute impédance et en pied de colonne. Le dispositif comporte toujours une partie analogique 10 pour le stockage de la charge électrique et une partie numérique 20 pour numériser la valeur stockée. La partie numérique est sensiblement identique à celle de la figure 1, le « trigger » 9 étant remplacé par un comparateur 21. Comme pour le « trigger », la sortie du comparateur 21 est connectée aux entrées des portes 13.

La partie analogique 10 comporte toujours une batterie de N condensateurs 1, 11 en parallèle dont les capacités augmentent selon la même progression géométrique que le montage de la figure 1. Les électrodes individuelles sont connectées au même type de branchement de commutateurs 100, 101, 102, 103, 104. Cependant, le commutateur 104 relié en série avec l'électrode individuelle n'est plus connecté à un amplificateur mais à un potentiel de masse. Pendant la phase d'intégration, c'est-à-dire pendant le stockage de la charge électrique dans les condensateurs, ce transistor 104 est passant, l'électrode est alors mise au potentiel de masse 22. Par ailleurs, sur chacun de ces branchements individuels, deux commutateurs 100, 101 relient l'électrode individuelle à un potentiel haut Vlog et deux autres commutateurs 102, 103 relient cette même électrode au potentiel de masse. La tension Vlog est par exemple égale à l'excursion de tension acceptée sur la colonne à l'issue de la phase d'intégration de la charge sur les condensateurs.

L'électrode commune des condensateurs est toujours chargée par une colonne 14 elle-même alimentée par une source de courant 23. Au cours de la phase d'intégration le potentiel d'entrée varie et donc le potentiel de l'électrode commune reliée à cette entrée. Contrairement au montage basse impédance, dans le montage haute impédance c'est le potentiel de l'électrode commune qui varie, le potentiel des électrodes individuelles restant sensiblement fixe, égal sensiblement au potentiel de masse. Dans le montage basse impédance, le potentiel des électrodes individuelles varie et le potentiel de l'électrode commune reste sensiblement constant.

L'électrode commune est reliée à l'entrée d'un amplificateur 24 connecté en suiveur, la sortie de cet amplificateur étant reliée au condensateur d'échantillonnage 5 via le commutateur Lraz-Ech. La sortie de l'amplificateur 24 est par ailleurs relié à une entrée du comparateur 21, l'autre entrée du comparateur étant reliée à un potentiel Vseuil. La tension Vseuil est par exemple la valeur maximale de la tension de la colonne en fin d'intégration. La différence de tension Vseuil - Vlog est par exemple la valeur minimale de la tension de la colonne 14 en fin d'intégration.

Les électrodes communes sont par ailleurs reliées à un potentiel Vraz via un commutateur Raz. Lorsque ce dernier est passant, le potentiel des électrodes communes est réinitialisé à la tension Vraz. Cette tension Vraz est notamment choisie selon la symétrie de l'excursion du courant d'entrée.

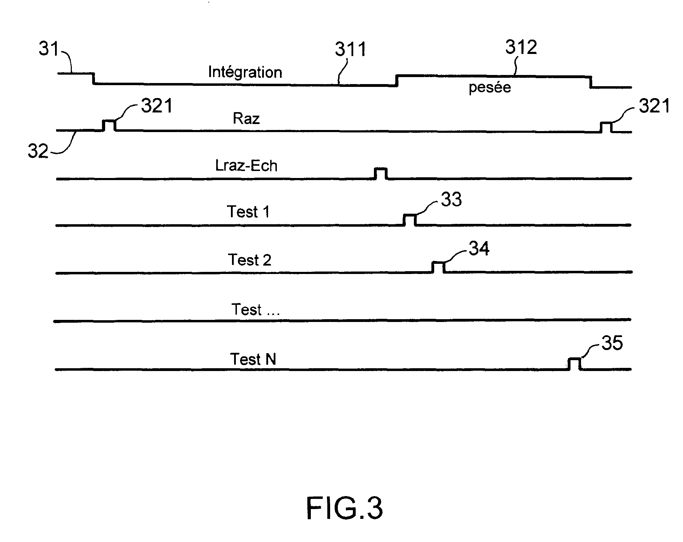

La figure 3 illustre par des chronogrammes les signaux de tests et les signaux commandant les différents commutateurs. Un premier signal 31 commande les commutateurs associés à l'électrode individuelle de chaque condensateur. Ce signal comporte deux phases :
- une première phase 311 correspond à l'intégration et au stockage des charges dans les condensateurs 1, 11, où ces derniers emmagasinent la charge électrique à mesurer, pendant cette phase le signal 31 est par exemple à l'état bas ou à zéro ;
- une deuxième phase 312 correspond à la pesée pour la quantification numérique, c'est-à-dire à la détermination de la valeur numérique de la charge emmagasinée, cette pesée étant décrite par la suite, pendant cette phase le signal 31 est dans l'état inverse du précédent, c'est-à-dire par exemple à l'état haut ou à 1.

Pendant la phase d'intégration 311, le courant de charge des condensateurs 1, 11 est par exemple amené par la colonne 14.

Dans le cas du montage basse impédance de la figure 1, les électrodes individuelles des condensateurs ne sont pas reliées aux potentiels Vun et Vzéro. Les commutateurs 100, 103 reliant cette électrode à ces potentiels sont alors commandés à l'état ouvert. Les électrodes individuelles des condensateurs sont toutes reliées à la sortie de l'amplificateur 3 via les commutateurs série 104 commandés à l'état passant.

Dans le cas du montage haute impédance de la figure 2, les électrodes individuelles sont reliées à la masse mécanique, le potentiel des électrodes communes évoluant avec la charge électrique.

Un signal impulsionnel 32 représente l'état du commutateur 4 ou Raz de remise à zéro pour les deux montages. Le signal 32 montre que ce commutateur est commandé à l'état passant 321 en début de phase d'intégration 31 pour permettre la remise à l'état initial des condensateurs. Dans l'exemple du montage basse impédance, lorsque le commutateur 4 est à l'état passant, il court-circuite les condensateurs, ce qui provoque leur décharge.

Pendant la phase d'intégration 311 les condensateurs sont donc tous branchés à la sortie de l'amplificateur 3 pour le montage basse impédance, ou à la masse mécanique pour le montage haute impédance.

En fin de phase d'intégration 311, avant la phase de numérisation 312, un signal impulsionnel Lraz-ech effectue simultanément la réinitialisation logique des mémoires 12 et la mémorisation de la tension analogique sur le condensateur d'échantillonnage 5. A cet effet, pour effectuer cette réinitialisation le signal Lraz-ech passe par exemple à l'état haut pour commander à la fermeture le commutateur Lraz-Ech reliant la sortie de l'amplificateur 3, 24 au condensateur d'échantillonnage. Par ailleurs, ce même signal Lraz-ech commande les entrées ou « reset » des mémoires 12 à la réinitialisation, à l'exception de la mémoire du bit de poids fort, le bit 1. Le signal Lraz-ech est relié à l'entrée « set » de la mémoire. De la sorte, lors de la ré-inialisation logique, en fin de phase d'intégration, le signal Lraz-ech met le bit MSB à l'état 1 et tous les autres bits à l'état 0. En d'autre terme, la sortie Q de la mémoire MSB est à l'état 1 et les sorties Q des autres mémoires sont à l'état 0. Cette mémoire MSB associée au premier condensateur 1 de la batterie, ayant la plus grande valeur de capacité, par exemple C/2 contrôle à lui seul la moitié de la capacité de stockage. Les autres bits contrôlent l'autre moitié.

En fin de phase d'intégration, le potentiel atteint sur le condensateur d'échantillonnage est quelconque, il correspond soit au potentiel de l'électrode commune pour le montage haute impédance, soit au potentiel des électrodes individuelles pour le montage basse impédance.

Pendant la phase de numérisation 312, le dispositif selon l'invention cherche la combinaison de sections de condensateurs qui, contenant la même quantité de charge, se trouve à un potentiel défini, la combinaison représentant l'équivalent binaire du potentiel atteint et de la charge accumulée. A cet effet des signaux de test impulsionnels 33, 34, 35 vont successivement être envoyés sur les entrées des portes logiques 13. Dans cette phase 312, les électrodes individuelles peuvent être connectées aux potentiels Vun et Vzéro, ou Vlog et de masse via les commutateurs 100, 101, 102,103. Un des commutateurs 100, 103, situé entre une électrode individuelle et un de ces potentiels, est par exemple en permanence à l'état passant pendant cette phase. Un commutateur 101 commandé à l'état passant par la sortie Q de la mémoire 12 associée relie l'électrode au potentiel Vlog ou Vun, un autre commutateur 102 commandé à l'état passant par la sortie inverse de Q relie l'électrode au potentiel Vzéro ou de masse. De cette manière et selon l'état de la sortie Q un transfert de charge est effectué entre les condensateurs. Plus précisément, les commutateurs 100, 101, 102,103 permettent de porter chacune des électrodes individuelles à deux potentiels distincts, correspondant aux deux états logiques, c'est-à-dire transférer ou ne pas transférer la charge électrique portée par chaque condensateur 1, 11 de la batterie à l'ensemble des autres éléments de la batterie.

Pour décrire l'établissement de la valeur numérique on se réfère à titre d'exemple au montage haute impédance de la figure 2. A priori, la tension atteinte au niveau de l'électrode commune est quelconque donc inconnue. Cette tension est comparée avec la tension Vseuil par le comparateur 21. Si l'électrode commune à atteint cette valeur Vseuil, valeur maximal prévue, la sortie du comparateur 21 est par exemple déjà à l'état 0 en début de phase de numérisation, la tension Vseuil étant reliée à l'entrée positive du comparateur et la sortie de l'amplificateur suiveur 24 étant reliée à l'entrée positive. Dans ce cas les portes logiques 13, qui sont par exemple des portes « et », voient leur sortie passer à l'état 0. Ces sorties étant reliées aux entrées « Reset » des mémoires, il en résulte que toutes les sorties des mémoires sont forcées et mémorisées à l'état 0. Les bits affichent donc la valeur 0. Dans ce cas, la valeur Vseuil atteinte est codée à 00 ...0.

Si la tension en sortie de l'amplificateur suiveur 24 est inférieure à Vseuil, la sortie du comparateur 21 reste à l'état 1 et n'influence donc pas la sortie des portes logiques 13. Un premier signal de test Test 1 est alors envoyé sur une entrée de la porte logique 13 de la mémoire 12 de poids fort. La pesée des charges se déroule ainsi en N étapes successives contrôlées par les signaux Test 1 à Test N. Dans un système multivoies, un unique dispositif séquenceur, non représenté sur les figures, fournit ces signaux qui sont distribués à toutes les voies, par exemple en entrée des portes logiques 13. A chaque étape de conversion, le signal de test :
- d'une part valide ou invalide, selon l'état du comparateur 21, le bit de l'étape précédente ;
- d'autre part active le bit suivant pour le soumettre au test par le comparateur 21.

Dans ce dernier test, la sortie Q de la mémoire 12 correspondant au bit suivant est activée de façon à commander l'état passant des commutateurs 101, 102 pour porter l'électrode du condensateur correspondant à ce bit, soit au potentiel haut, Vun ou Vlog, soit au potentiel bas, Vzéro ou de masse. Le bit est validé si, à la suite au transfert de charge du condensateur vers les autres condensateurs, la sortie du comparateur 9, 21 passe à l'état 1.

Lors de la phase d'intégration, les condensateurs 1, 11 étant en parallèle, ils ont tous la même tension Vc entre leurs électrodes, seule la charge varie d'un condensateur à l'autre selon la progression géométrique des valeurs de capacité. Plus la capacité est importante, plus la charge accumulée est importante. Dans le cas des montages des figures 1 et 2, le premier condensateur accumule à lui seul la moitié de la charge totale. Dans la phase de numérisation les électrodes individuelles étant déconnectées, les condensateurs ne sont plus en parallèle et leur potentiel pourra varier librement en fonction de la charge accumulée.

Il est à noter que les capacités parasites peuvent être non négligeables. La capacité entre l'électrode commune, et la masse mécanique peut être significativement non négligeable en comparaison de la capacité d'intégration des condensateurs 1, 11. Elle stocke une charge qui ne peut pas être numérisée.

Dans le cas du montage haute impédance, le potentiel d'entrée est égal à la tension Vraz avant l'intégration et à la tension Vseuil après la numérisation. Un décalage ou « offset » de charge décale donc systématiquement la mesure mais n'est pas gênant puisqu'il est invariant et égal à la quantité Q = (Vseuil - Vraz). Cₜₒₜₐₗ où Cₜₒₜₐₗ représente la capacité totale parasite. Dans le cas d'un imageur photovoltaïque par exemple, le courant d'entrée est unidirectionnel sortant. Dans ce cas l'initialisation du potentiel d'entrée est à la valeur maximale de l'excursion et Vraz = Vseuil. Dans le cas du montage basse impédance, à la fin de la pesée l'entrée de l'amplificateur 3, devenu comparateur, est revenue très près du potentiel V_{Gris}, à un bit de poids faible près, potentiel qu'elle avait perdu pendant l'intégration. Cela signifie qu'aucune erreur de charge n'est à craindre en ce point et que la capacité parasite entre ce point et la masse, aussi grande soit-elle, est sans conséquence sur la conversion. Les capacités parasites entre les électrodes individuelles des condensateurs et la masse ne sont pas davantage gênante puisque ces points sont contrôlés en tension, d'abord par la sortie de l'amplificateur, ensuite par les commutateurs commandés par les signaux Q et Q inversé.

Un dispositif selon l'invention présente notamment les avantages suivant :
- il permet un bon rendement en surface, en minimisant la proportion de surface du silicium utilisé pour le stockage des charges électriques ;
- l'encombrement n'est guère supérieur à un circuit classique en pied de colonne, en effet tous les organes sont réutilisés, en particulier les condensateurs de stockage, les amplificateurs ainsi que les circuits logiques ;
- il permet une compatibilité avec une utilisation analogique du circuit, il y a en effet une double lecture analogique, en sortie de l'amplificateur 8, et numérique ;
- il est insensible à la capacité parasite de la colonne, aussi grande soit-elle.

Un dispositif selon l'invention a par ailleurs de nombreuses applications. Le montage haute impédance convient particulièrement pour des imageurs photovoltaïques, dans les domaines visibles ou infrarouges notamment. Le montage basse impédance convient notamment pour des imageurs bolométriques, le bolomètre étant souvent associé à un dispositif d'ébasage du courant pour former un pont de mesure. Dans ce cas, il est préférable que le potentiel d'entrée ne varie pas au cours de l'intégration de la charge.

Le montage basse impédance de la figure 1 peut par exemple comporter un commutateur 19 placé en entrée, à l'arrivée du courant de charge des condensateurs. Ce commutateur 19 est par exemple nécessaire lorsque le courant d'entrée ne peut être coupé précisément à la fin de la période d'intégration. C'est notamment le cas avec un imageur infrarouge bolométrique lorsque le courant résulte de la différence entre le courant du détecteur et un courant d'ébasage et qu'il n'est pas possible de garantir de les couper simultanément.

De même, le montage de la figure 2 peut comporter un commutateur 19 placé au même endroit, en entrée. Ce commutateur est alors fermé pendant la phase d'intégration et ouvert pendant la phase de numérisation.

Avantageusement, un dispositif selon l'invention permet de réaliser une conversion inverse, c'est-à-dire une conversion numérique - analogique. Pour cela :
- les mémoires 12 sont par exemple écrite depuis le bus à une valeur numérique donnée, ces écritures nécessitant notamment quelques portes logiques supplémentaires non représentées, les électrodes individuelles des condensateurs 1, 11 étant alors portées à Vun ou Vzéro selon l'état de chaque mémoire dans le cas du montage haute impédance ;
- le commutateur de remise à zéro 4, Raz est momentanément fermé, ce qui a pour effet de pré-charger les condensateurs 1, 11 et d'amener l'entrée au potentiel V_{Gris}.

Le dispositif passe ensuite en phase d'intégration, la sortie de l'amplificateur 3 se place alors à un potentiel compris entre Vzéro et Vun en correspondance avec le code numérique initial.

Cette fonction optionnelle de conversion numérique - analogique pourrait notamment permettre de configurer des fonctions analogiques à l'intérieur d'un circuit imageur par exemple en utilisant le bus numérique de sortie. La tension analogique obtenue peut servir en pied de colonne pour diverses fonctions, par exemple de correction.

## Revendications

1. Dispositif de mesure d'une charge électrique sous forme d'une valeur numérisée codée sur N bits, **caractérisé en ce qu'**il comporte au moins :
- une batterie de N condensateurs (1, 11) pour intégrer la charge, les condensateurs ayant une électrode commune destinée à être reliée à une source de courant fournissant la charge, chaque condensateur ayant une électrode individuelle, les valeurs des capacités des condensateurs étant en progression géométrique, un condensateur correspondant à un bit Q de la valeur numérisée ;
- des commutateurs (100, 101, 102, 103, 104) connectés sur chaque électrode individuelle fonctionnant selon deux phases, une phase d'intégration et une phase de numérisation ;
- des moyens (3, 12, 24) pour commander les commutateurs lesdits commutateurs connectant dans la phase d'intégration (311) les condensateurs en parallèle pour intégrer la charge dans les condensateurs (1, 11) et permettant dans la phase de numérisation (312) de porter chacune des électrodes individuelles à des premier et second potentiels distincts, correspondant aux deux états logiques du bit, pour transférer ou ne pas transférer la charge portée par le condensateur à l'ensemble des autres condensateurs de la batterie ;
- une unité logique (20) pour réaliser, dans la phase de numérisation, N tests appliqués successivement à chacun des N condensateurs de la batterie, chaque test consistant à relier l'électrode individuelle du condensateur testé au premier potentiel, à comparer le potentiel atteint par l'électrode commune à un potentiel défini (Vseuil), à définir la valeur du bit Q correspondant au condensateur testé en fonction du résultat de comparaison, puis à relier l'électrode individuelle au second potentiel uniquement si le bit Q est égal à une valeur prédéfinie.

2. Dispositif selon la revendication 1, **caractérisé en ce qu'**une électrode individuelle d'un condensateur (1,11) est connectée un circuit de transfert de charge comportant des commutateurs (100, 101, 102, 103), ladite électrode étant reliée électriquement :
- à un potentiel haut (Vun, Vlog) par deux commutateurs en série, un premier commutateur (100) étant commandé à l'état passant dans la phase de numérisation, l'état de l'autre commutateur (101) étant fonction de l'état Q mémorisant la valeur du bit associé au condensateur (1, 11) ;
- à un potentiel bas (Vzéro, 22), par deux commutateurs en série, un premier commutateur (103) étant commandé à l'état passant dans la phase d'intégration, l'état de l'autre commutateur (102) étant fonction de l'état inverse de l'état Q précédent.

3. Dispositif selon l'une quelconque des revendications précédentes, **caractérisé en ce qu'**il comporte un commutateur (Raz) pour initialiser la tension entre les électrodes des condensateurs (1, 11).

4. Dispositif selon l'une quelconque des revendications précédentes, **caractérisé en ce qu'**il comporte un circuit d'échantillonnage du potentiel défini en fin de phase de numérisation (312).

5. Dispositif selon la revendication 4, **caractérisé en ce que** le circuit d'échantillonnage comporte un condensateur (5) en série avec un commutateur (Lraz-Ech).

6. Dispositif selon l'une quelconque des revendications précédentes, **caractérisé en ce que** chaque électrode individuelle est connectée en série avec un commutateur (104) la reliant électriquement à la sortie d'un amplificateur (3), une entrée de l'amplificateur (3) étant reliée à un potentiel de référence (V_{Gris}) et l'autre entrée étant reliée à l'électrode commune, le commutateur (104) étant commandé à la fermeture pendant la phase d'intégration (312).

7. Dispositif selon la revendication 6, **caractérisé en ce que** la sortie de l'amplificateur (3) est reliée à l'entrée d'un comparateur (9).

8. Dispositif selon l'une quelconque des revendications 1 à 5, **caractérisé en ce que** chaque électrode individuelle est connectée en série avec un commutateur (104) la reliant électriquement à un potentiel fixe (22), le commutateur (104) étant commandé à la fermeture pendant la phase d'intégration (312).

9. Dispositif selon l'une quelconque des revendications précédentes, **caractérisé en ce que**, lors de la phase d'intégration, les condensateurs étant en parallèle, ils ont la même tension (Vc) entre leurs électrodes.
